# EUROPEAN PATENT APPLICATION

(11) **EP 0 739 781 A2**
(43) Date of publication of application: **30.10.1996**
(21) Application number: 96302906.1
(22) Date of filing: 25.04.1996
(51) Int. Cl.: B60R 16/02

(54) **Power supplying system for a caravan**

(30) Priority: 25.04.1995 GB 9508339; 17.01.1996 GB 9600916
(71) Applicant: John, Janice Michael, Nr. Pontypridd, Mid Glamorgan CF38 1AN (GB)
(72) Inventor: Scane, Mervyn William, Nr. Pontypridd, Mid Glamorgan, CF38 1AN (GB)
(74) Representative: James, Michael John Gwynne

(57) **Abstract**

A ventilation cover construction comprises a cover 1 and a solar panel 5. The cover has a depressed recessed region 4 within which the solar panel 5 is mounted and is fixed by means of bolts 6 which pass through the body of the cover 1. A sealant is provided in the holes through which the bolts pass. The solar panel comprises a steel backing sheet 10 covered by a white reflective sheet 11 on which are mounted individual solar cells 12. These are linked together and form single circuit from which there are power cables. The solar cells 12 are sealed in place by a transparent silicone sheet 13.

## Description

Caravans are often left on site for long periods of time. Nevertheless, it may be desirable to maintain power to systems (such as an alarm system) within the caravan during that time. One problem is that a battery power source can run down.

According to the invention there is provided a ventilation cover for the roof of a caravan or the like and including a solar panel comprising individual solar cells linked to create a single circuit to provide an electrical supply source, mounted on a backing sheet and protected by a covering sheet of clear material, the ventilation cover defining a recessed central section in the form of an external depression to receive the solar panel, the solar panel being fixed in place in the external depression with a waterproof seal.

Ideally the covering sheet is a transparent silicone sheet. The backing sheet is preferably formed from a reflective material, for example a steel sheet, but it is possible for the backing sheet to be of a generally clear material, for example acrylic. The central section of the cover could then be formed also from a clear acrylic material. This allows light through the ventilation cover and thus into the interior of the caravan or the like.

The solar panel is best glued in place in said recess. The solar panel may be secured by bolts passing through the ventilation cover with a waterproof sealant in the holes through which the bolts pass.

The solar panel may be connected to an alarm system and/or to a recharging unit of a rechargeable battery. This can maintain the operation of an alarm system even if the caravan is left for long periods of time.

Ideally, the central section of the cover projects outwardly of the surrounding outer face of the cover, so that the internal air circulation gap within the cover is not compromised.

The invention may be performed in various ways and a preferred embodiment thereof will now be described, with reference to the accompanying drawings, in which:
Figure 1 is a stylised external view of a ventilation cover of the invention mounted on a caravan;
Figure 2 is a plan view of a solar panel forming part of the ventilation cover of the invention; and
Figure 3 is a section through a ventilation cover incorporating the solar panel of Figure 2.

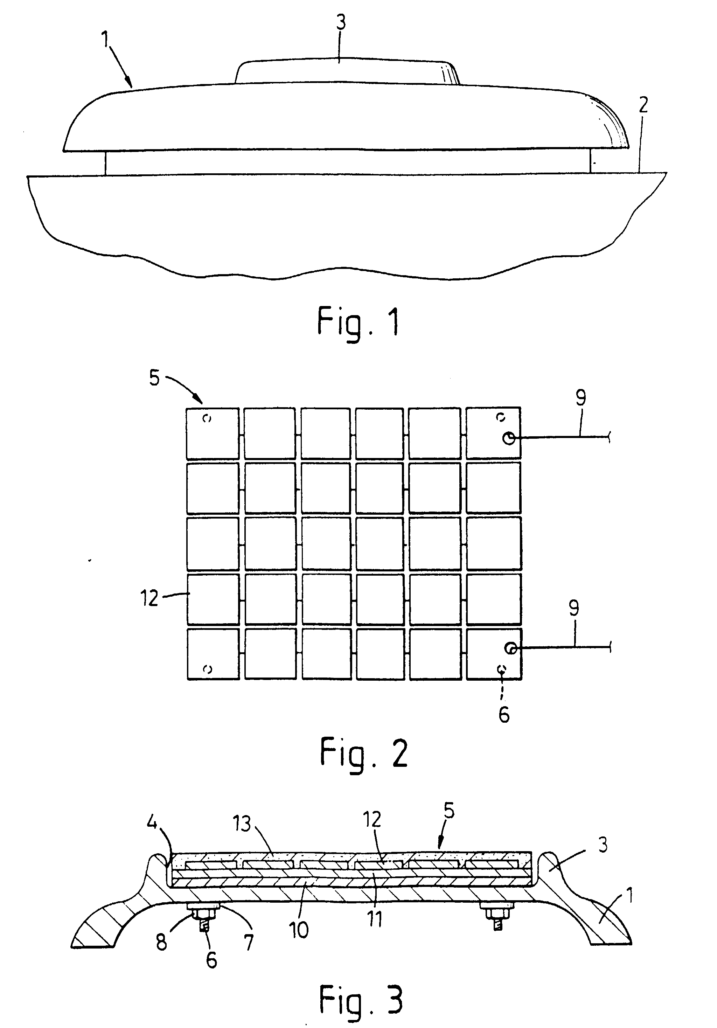

The cover 1 shown in Figure 1 is raised above the roof surface 2 of a caravan so as to allow air to circulate and gases to leave through the roof of the caravan. The design of the cover is such as to provide an internal air circulation region meeting particular approved standards.

The ventilation cover of this invention (as shown in Figures 2 and 3) is modified to incorporate a central section 3 defining a depressed recessed region 4 within which a solar panel 5 is mounted and is fixed by means of bolts 6 which pass through the body of the cover 1. A sealant is provided in the holes through which the bolts pass and the bolts are held in place by large washers 7 and nuts 8. Alternatively, the solar panel 5 may be held in place in the depression 4 by a bonding agent. This preferably fills the gap between the panel 5 and the depression 4 so that water cannot collect, and seals any opening in the cover 1 through which power cables 9 (figure 4) will pass.

The solar panel comprises a steel backing sheet 10 covered by a white reflective sheet 11 on which are mounted individual solar cells 12. These are linked together and form single circuit from which there are the power cables 9. The solar cells 12 are sealed in place by a transparent silicone sheet 13 so that sunlight can be received by the solar panel 5. The panel is designed to create electrical power which can be fed through the cables 9 to power, for example, an alarm system within the caravan.

The positioning of the solar panel 5 is such that it does not interfere with the normal air circulation within the cover nor with mounting structures normally fitted into the cover.

## Claims

1. A ventilation cover for the roof of a caravan or the like and including a solar panel comprising individual solar cells linked to create a single circuit to provide an electrical supply source, mounted on a backing sheet and protected by a covering sheet of clear material, the ventilation cover defining a recessed central section in the form of an external depression to receive the solar panel, the solar panel being fixed in place in the external depression with a waterproof seal.

2. A ventilation cover according to Claim 1, wherein the covering sheet of clear material is a transparent enclosing silicone sheet.

3. A ventilation cover according to Claim 1 or Claim 2, wherein the central section of the cover is formed from a clear acrylic material.

4. A ventilation cover according to any one of Claims 1 to 3, wherein the solar panel is glued in place in said recess.

5. A ventilation cover according to any one of Claims 1 to 4, wherein the solar panel is secured by bolts passing through the ventilation cover with a waterproof sealant in the holes through which the bolts pass.

6. A ventilation cover according to any one of Claims 1 to 5, wherein the backing sheet is of reflective material, or of a generally clear material.

7. A ventilation cover according to any one of Claims 1 to 5, wherein the backing sheet of the solar panel is a steel sheet.

8. A ventilation cover according to anyone of Claims 1 to 7, wherein the central section of the cover incorporating the recess projects outwardly of the surrounding outer face of the cover.

9. A ventilation cover according to any one of Claims 1 to 8, wherein the solar panel is connected to an alarm system and/or a recharging unit of a rechargeable battery.

10. A ventilation cover for the roof of a caravan or the like and substantially as herein described with reference to the accompanying drawings.
